# EUROPEAN PATENT APPLICATION

(11) **EP 4 521 290 A1**
(43) Date of publication of application: **12.03.2025**
(21) Application number: 24194307.5
(22) Date of filing: 13.08.2024
(51) Int. Cl.: G06F 30/20, G06Q 10/04

(54) **INFORMATION PROCESSING PROGRAM, INFORMATION PROCESSING DEVICE, AND INFORMATION PROCESSING METHOD FOR DECISION MAKING**

(30) Priority: 06.09.2023 JP 2023144801
(71) Applicant: FUJITSU LIMITED, Kawasaki-shi, Kanagawa 211-8588 (JP)
(72) Inventor: ITO, Toshio, 211-8588 Kawasaki-shi, Kanagawa (JP); ICHIKAWA, Shizuko, 211-8588 Kawasaki-shi, Kanagawa (JP)
(74) Representative: Hoffmann Eitle

(57) **Abstract**

An information processing program for causing a computer to perform a process includes: acquiring a plurality of parameters for a measure; performing a plurality of simulations of the measure in a virtual space, based on the plurality of parameters acquired; performing relative evaluation based on results of the plurality of simulations performed; outputting a combination of indexes of a plurality of viewpoints that are regarded as important by stakeholders with respect to the measure, based on a result of the relative evaluation; and identifying a portion that is common among the stakeholders from the output combination.

## Description

### FIELD

The embodiment discussed herein is related to an information processing program, an information processing device and an information processing method.

### BACKGROUND

For a complicated social problem, it is required to consider balanced measures by taking into account multiple evaluation indexes from a wide variety of viewpoints rather than a single viewpoint. Here, the social problem may be a problem related to urban transportation or the like, for example, and the multiple evaluation indexes are carbon dioxide (CO₂) emission reduction, economic revitalization, convenience improvement, and the like to be expected from the measures against the problem.

### [Citation List]

### [Patent Literature]

[PTL 1] Japanese Laid-open Patent Publication No. 2021-170187 is disclosed as related art.

### SUMMARY OF INVENTION

### PROBLEMS

However, while the multiple evaluation indexes affect one another, what is regarded as important varies depending on the stakeholders related to the measures, and there is a case where it is not possible to clarify beforehand the viewpoints that are regarded as important by the stakeholders. Under such circumstances, the stakeholders are required to agree on the measure to be adopted.

In one aspect, the objective is to make it easier for stakeholders to agree on a measure against a problem in which multiple evaluation indexes affect one another.

### Solution to Problem

According to an aspect of the embodiments, an information processing program for causing a computer to perform a process includes: acquiring a plurality of parameters for a measure; performing a plurality of simulations of the measure in a virtual space, based on the plurality of parameters acquired; performing relative evaluation based on results of the plurality of simulations performed; outputting a combination of indexes of a plurality of viewpoints that are regarded as important by stakeholders with respect to the measure, based on a result of the relative evaluation; and identifying a portion that is common among the stakeholders from the output combination.

### EFFECTS OF INVENTION

In one aspect, it is possible to make it easier for stakeholders to agree on a measure against a problem in which multiple evaluation indexes affect one another.

### BRIEF DESCRIPTION OF DRAWINGS

FIG. 1 is a diagram illustrating an example configuration of an information processing system 1 according to the present embodiment;
FIG. 2 is a diagram illustrating an example configuration of an information processing device 10 according to the present embodiment;
FIGS. 3A and 3B are tables illustrating an example of measure parameters according to the present embodiment;
FIG. 4 is a diagram illustrating an example of simulation results according to the present embodiment;
FIG. 5 is a diagram illustrating an example of relative evaluation according to the present embodiment;
FIG. 6 is a diagram illustrating an example of a measure search process according to the present embodiment;
FIG. 7 is a diagram illustrating an example of a Pareto frontier according to the present embodiment;
FIG. 8 is a diagram illustrating an example of a parallel coordinates plot according to the present embodiment;
FIG. 9 is a diagram illustrating an example of a problem in consensus formation;
FIG. 10 is a diagram illustrating an example of a goodness distribution according to the present embodiment;
FIG. 11 is a diagram illustrating an example of consensus formation according to the present embodiment;
FIG. 12 is a diagram illustrating an example of a problem in relative evaluation pair selection;
FIG. 13 is a diagram illustrating an example of selection of a relative evaluation pair according to the present embodiment;
FIG. 14 is a diagram illustrating an example of global pair selection according to the present embodiment;
FIG. 15 is a diagram illustrating an example of midrange pair selection according to the present embodiment;
FIG. 16 is a diagram illustrating an example of local pair selection according to the present embodiment;
FIG. 17 is a flowchart illustrating an example of the flow of a measure search process according to the present embodiment; and
FIG. 18 is a diagram illustrating an example hardware configuration of the information processing device 10 according to the present embodiment.

### DESCRIPTION OF EMBODIMENTS

In the description below, examples of an information processing program, an information processing device, and an information processing method according to the present embodiment are explained with reference to the drawings. Note that the present embodiment is not limited by these examples. Furthermore, the respective examples may be appropriately combined within a range without inconsistency.

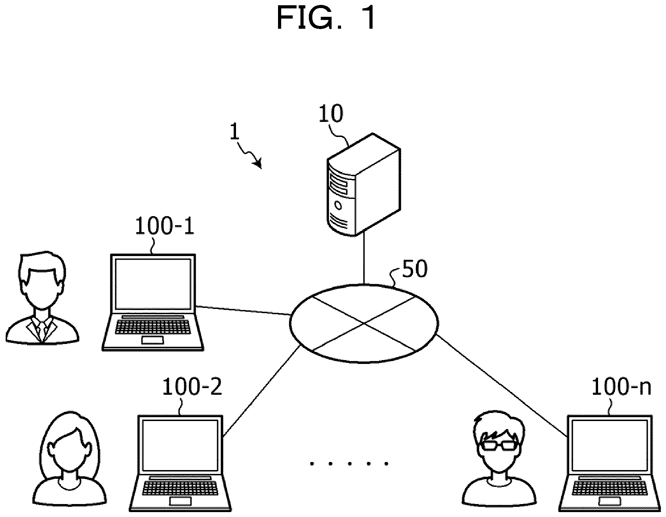

First, an information processing system for carrying out the present embodiment is described. FIG. 1 is a diagram illustrating an example configuration of an information processing system 1 according to the present embodiment. As illustrated in FIG. 1, the information processing system 1 is a system in which an information processing device 10 and information processing terminals 100-1 to 100-n (n being a natural number: hereinafter collectively referred to as "information processing terminals 100") are coupled so as to be able to communicate with each other via a network 50, for example.

As the network 50, various communication networks such as the Internet may be adopted, for example, regardless of whether the communication network is wired or wireless. Also, as the network 50, instead of a single network, an intranet and the Internet may be configured via a network device such as a gateway or some other device (not illustrated in the drawing), for example.

The information processing device 10 may be a desktop personal computer (PC), a notebook PC, a server computer, or the like that is managed by a service provider or the like that searches for measures and presents a draft agreement for the measures, for example.

For example, the information processing device 10 acquires a plurality of parameters for the measures, and performs a plurality of simulations for the measures in a virtual space based on the acquired plurality of parameters. The simulations may be performed as digital rehearsals of the measures on a constructed digital twin that is an existing technology, for example.

Also, the information processing device 10 performs relative evaluation based on results of the plurality of the performed simulations, for example. The relative evaluation may be performed by presenting a simulation result of each measure to each stakeholder via the information processing terminals 100, and each stakeholder inputting a result of evaluation of each measure, for example.

Further, based on a result of the relative evaluation, for example, the information processing device 10 outputs a combination of indexes of a plurality of viewpoints that are regarded as important by the stakeholders for the measures, and identifies a portion that is common among the stakeholders from the output combination. Furthermore, the information processing device 10 presents the common portion identified herein as a draft agreement on measures to each of the stakeholders via the information processing terminals 100, for example.

Note that FIG. 1 illustrates the information processing device 10 as one computer. However, the information processing device 10 may be a distributed computing system including a plurality of computers. Alternatively, the information processing device 10 may be a cloud computer device being managed by a service provider that provides cloud computing services.

The information processing terminals 100 may be desktop PCs or notebook PCs, or mobile terminals such as smartphones or tablet PCs that are used by the respective stakeholders, for example. Each stakeholder inputs an evaluation result for each of the measures, and displays a result of the simulation of each of the measures provided from the information processing device 10 and a draft agreement for each of the measures, for example, via the information processing terminals 100.

Note that, in the information processing terminals 100, an application for inputting a result of evaluation of each measure, displaying a result of simulation of each measure, a draft agreement for each measure, or the like may be installed in advance, for example. Alternatively, the information processing terminals 100 may access a website or an application in the information processing device 10, and input a result of evaluation of each measure or the like, for example. In this case, an application for inputting a result of evaluation of each measure or the like may not be installed in the information processing terminals 100.

### [Functional Configuration of the Information Processing Device 10]

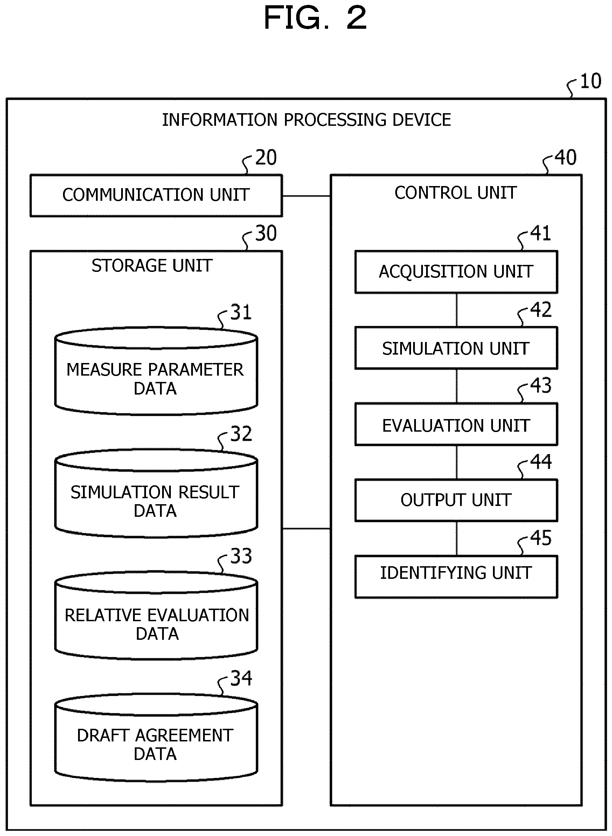

Next, the functional configuration of the information processing device 10 serving as an execution subject of the present embodiment is described. FIG. 2 is a diagram illustrating an example configuration of the information processing device 10 according to the present embodiment. As illustrated in FIG. 2, the information processing device 10 includes a communication unit 20, a storage unit 30, and a control unit 40.

The communication unit 20 is a processing unit that controls communication with another device, and is a communication interface such as a network interface card, or a universal serial bus (USB) interface, for example.

The storage unit 30 has a function of storing various kinds of data and a program to be executed by the control unit 40, and stores measure parameter data 31, simulation result data 32, relative evaluation data 33, draft agreement data 34, and the like, for example.

In the measure parameter data 31, information regarding parameters for measures (hereinafter referred to as "measure parameters") and the like, for example. Here, an example of a measure is described more specifically.

For example, a business operator plans a measure called shared e-scooters as one of the services for residents. In this measure, a plurality of e-scooters is placed in each station among a plurality of stations installed in a city, for example. Note that an e-scooter may also be called an electric scooter or the like, for example. Furthermore, the e-scooters are shared by residents in the city, for example. With this arrangement, a resident can rent an e-scooter at the nearest station by paying some charges, for example. Also, the resident can drop off or return the e-scooter at any of the stations, for example.

Furthermore, the e-scooters are deployed at each station among the plurality of stations early in the morning or late at night or the like, for example. For example, a truck carrying a plurality of e-scooters visits each station, and an occupant of the truck places e-scooters at each station. Here, the costs to be imposed on the business operator and the revenue to be earned by the business operator change depending on the initial number of e-scooters deployed at the stations, for example. Further, the costs include the fuel cost for the truck that transports the e-scooters, the labor cost for the occupant, and the like, for example. Furthermore, the revenue includes the rental fees (rents) for the e-scooters, for example. Further, a car emits a larger amount of CO₂ than an e-scooter, and therefore, it is expected to determine the number of e-scooters to be deployed from a viewpoint of an environmental problem such as global warming.

In such an e-scooter measure, the convenience of the residents can be improved, and for example, the community can be rejuvenated, or the like. Meanwhile, business operators and local governments need to take into consideration, for example, costs, revenue, CO₂ emissions, and the like. In other words, for example, in the measure with e-scooters, there are stakeholders such as the residents, the business operator, the local government, and the like, and there may be a case where the matters that are regarded as important by the respective stakeholders are different, or the matters that need to be taken into consideration are not clear.

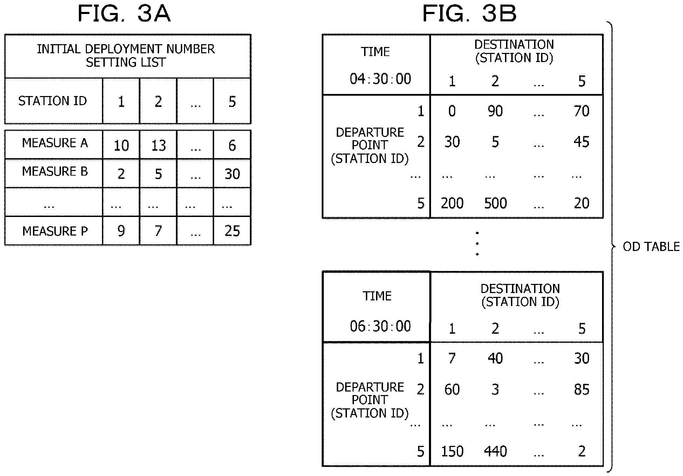

Further, in the case of such a measure with e-scooters, a measure parameter is the initial number of e-scooters to be deployed at each station in the early morning or late night or the like, for example. The initial number of such e-scooters to be deployed may be data as illustrated in FIGS. 3A and 3B, for example.

FIGS. 3A and 3B are tables illustrating an example of the measure parameters according to the present embodiment. An initial deployment number setting list illustrated in FIG. 3A is an example of the measure parameters, and is stored in the measure parameter data 31. Also, as illustrated in FIG. 3A, for example, the initial deployment number setting list may include the initial number of e-scooters to be deployed at each station uniquely identified by a station ID, and the initial number of e-scooters to be deployed for each measure.

Further, an origin destination (OD) table as illustrated in FIG. 3B, for example, may be stored in the measure parameter data 31. The OD table indicates the amount of movement demand for e-scooters at each time, one point being set as the station at a departure place of an e-scooter, another point being set as the station at the destination, for example.

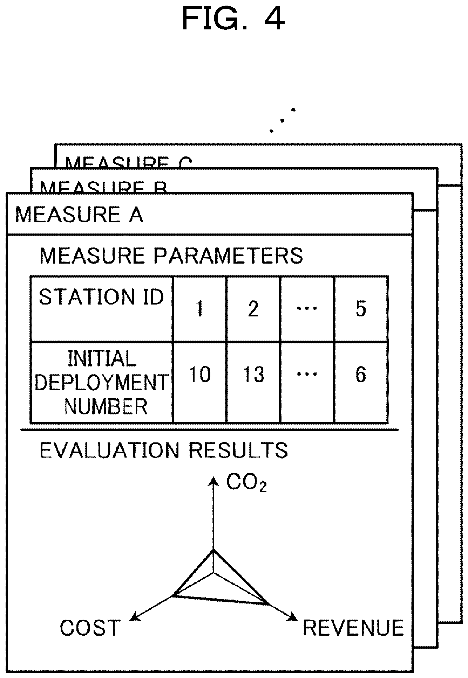

The simulation result data 32 stores simulations performed for the respective measures using the measure parameters, information regarding the results of the simulations, and the like, for example. The simulation result data stored in the simulation result data 32 may be data as illustrated in FIG. 4, for example.

FIG. 4 is a diagram illustrating an example of simulation results according to the present embodiment. As illustrated in FIG. 4, the simulation result data may include the measure parameters used in the simulations and the evaluation results for the respective measures, for example. Also, as illustrated in FIG. 4, for example, the evaluation results may be results for the respective evaluation indexes such as costs, revenues, and CO₂ emission amounts in a case where the measures are implemented. Note that, in the example in FIG. 4, the evaluation results by the three evaluation indexes are illustrated, but the number of evaluation indexes may be two, or may be four or larger.

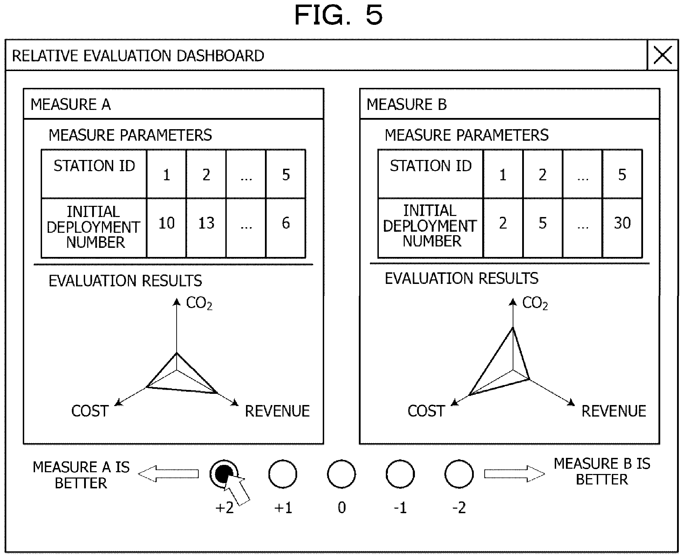

The relative evaluation data 33 stores information about the relative evaluation by each of the stakeholders with respect to the results of simulations of the respective measures, the results of the relative evaluations, and the like, for example. The relative evaluation data stored in the relative evaluation data 33 may be input for each of the stakeholders via a user interface (UI) as illustrated in FIG. 5, for example.

FIG. 5 is a diagram illustrating an example of relative evaluation according to the present embodiment. A relative evaluation dashboard illustrated in FIG. 5 is a UI for displaying simulation results of two measures, and allowing a stakeholder to input the better measure between the two, for example. The relative evaluation dashboard is presented from the information processing device 10 to each of the stakeholders via the information processing terminals 100, for example. As illustrated in FIG. 5, each stakeholder selects a radio button at the bottom of the relative evaluation dashboard, to input which measure is better, for example. As a result, relative evaluation for each measure is performed by each stakeholder, and the result is stored into the relative evaluation data 33. Note that the method for inputting relative evaluation as illustrated in FIG. 5 is merely an example, and the present embodiment is not limited to this.

The draft agreement data 34 stores information regarding a draft agreement on each measure based on the relative evaluation of each of the measures by each stakeholder, and the like, for example. Note that the draft agreement data stored in the draft agreement data 34 is generated by the information processing device 10 based on the data of the result of the relative evaluation performed by each of the stakeholders with respect to each of the measures, the data being stored in the relative evaluation data 33, for example. However, the details of the draft agreement data will be described later.

Note that the above information stored in the storage unit 30 is merely an example, and the storage unit 30 may store various kinds of information other than the above information.

The control unit 40 is a processing unit that is in charge of overall control of the information processing device 10, and is a processor or the like, for example. The control unit 40 includes an acquisition unit 41, a simulation unit 42, an evaluation unit 43, an output unit 44, and an identifying unit 45. Note that each processing unit is an example of an electronic circuit included in a processor, or an example of a process to be performed by the processor.

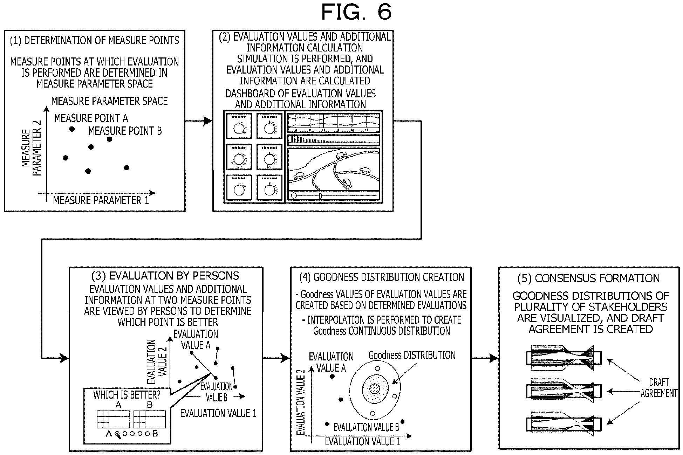

The acquisition unit 41 acquires a plurality of parameters for the measures, or, in other words, a plurality of measure parameters, for example. Since the parameters for the measures are set and stored beforehand in the measure parameter data 31, for example, the acquisition unit 41 acquires, from the measure parameter data 31, the measure parameters corresponding to the measures to be simulated. Here, the overall flow of a measure search process to be performed by the information processing device 10 is described with reference to FIG. 6.

FIG. 6 is a diagram illustrating an example of a measure search process according to the present embodiment. As illustrated in "(1) Determination of Measure Points" in FIG. 6, the acquisition unit 41 determines the measure parameters (strictly speaking, measure points in a measure parameter space) to be used for simulation, for example, and acquires the measure points. The measure points are used by the simulation unit 42 to perform simulation. The measure points to be used in the simulation may be determined in advance and be stored in the measure parameter data 31, or may be randomly determined and be acquired from the measure parameter data 31.

The simulation unit 42 performs a plurality of simulations for the measures in a virtual space, based on the plurality of parameters acquired by the acquisition unit 41, for example. For each measure, the simulation may be performed as a digital rehearsal of each measure on a constructed digital twin that is an existing technology, for example. Note that, as illustrated in "(2) Evaluation Values and Additional Information Calculation" in FIG. 6, the simulation unit 42 performs a simulation of each measure, for example, and calculates the evaluation value and other additional information with respect to each evaluation index. Then, the simulation unit 42 then generates a relative evaluation dashboard as illustrated in FIG. 5 as simulation results, for example, and stores the simulation results into the simulation result data 32.

The evaluation unit 43 performs relative evaluation based on the results of the plurality of simulations performed by the simulation unit 42, for example. As illustrated in "(3) Evaluation by Persons" in FIG. 6, for example, the relative evaluation may be evaluation as to which measure is better for each stakeholder viewing the relative evaluation dashboard generated as the simulation results. Also, the evaluation unit 43 stores, into the relative evaluation data 33, the relative evaluation made by each stakeholder with respect to the simulation results, for example.

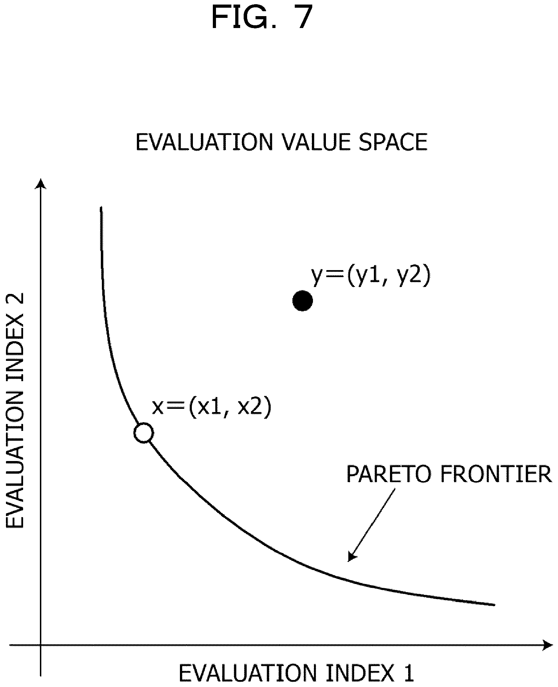

Note that the process of performing the relative evaluation with the evaluation unit 43 may include a process of generating a Pareto frontier, based on the results of the plurality of simulations performed by the simulation unit 42, for example. Then, the relative evaluation based on the results of the plurality of simulations on the Pareto frontier is then performed for each of the stakeholders, for example. Although the Pareto frontier is an existing technology, the Pareto frontier will be described below more specifically with reference to FIG. 7.

FIG. 7 is a diagram illustrating an example of the Pareto frontier according to the present embodiment. The example in FIG. 7 illustrates a Pareto frontier in an evaluation value space in which an evaluation index 1 is indicated by the x-axis, and an evaluation index 2 is indicated by the y-axis. On the Pareto frontier, with respect to an evaluation result x = (x1, ..., xn), in a case where all the evaluation results y = (y1, ..., yn) different from x do not satisfy yi ≤ xi (i = 1, ..., n), for example, x is called the optimal solution. Further, it indicates that there is no better solution than the Pareto frontier represented by a curve in FIG. 7.

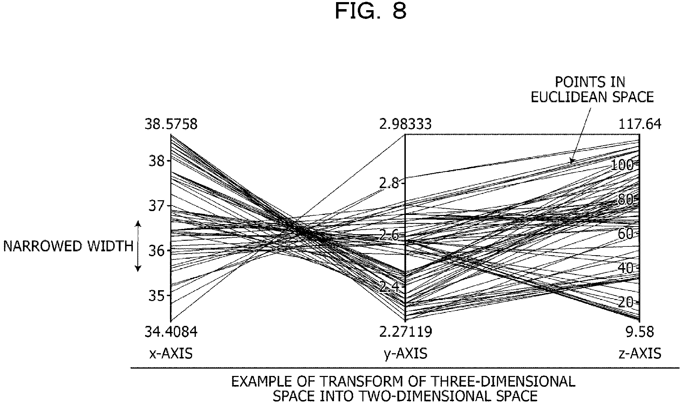

The output unit 44 outputs a combination of indexes from a plurality of viewpoints that are regarded as important by the stakeholders with respect to the measures, based on the results of the relative evaluation performed by the evaluation unit 43, for example. The process of outputting the combination may include a process of outputting the combination using a parallel coordinates plot in which points on the Pareto frontier are plotted, with each of the indexes being an axis, for example. Although the parallel coordinates plot is an existing technology, the parallel coordinates plot will be described below more specifically with reference to FIG. 8.

FIG. 8 is a diagram illustrating an example of a parallel coordinates plot according to the present embodiment. The example in FIG. 8 is a parallel coordinates plot in which points in a three-dimensional Euclidean space indicating the respective evaluation indexes with the three axes of x-, y-, and z-axes, respectively, are expressed in two dimensions. In the parallel coordinates plot, points can be narrowed down by reducing the width of the axes, for example. In the measure search processing according to the present embodiment, points on the Pareto frontier are output as a parallel coordinates plot, for example. Note that the parallel coordinates plot illustrated in FIG. 8 is an example in which a three-dimensional space indicating three evaluation indexes is expressed in two dimensions. In the parallel coordinates plot, however, a space of four or more dimensions can be expressed, or, in other words, points of four or more evaluation indexes can be expressed in two dimensions, for example.

The identifying unit 45 identifies a portion common among the stakeholders (the portion will be hereinafter referred to as a "common portion") from the combination of indexes of a plurality of viewpoints that are output by the output unit 44 and are regarded as important by the stakeholders with respect to the measures, for example. The process of identifying the common portion may be a process of identifying, as the common portion, a common portion among portions in which the respective indexes are equal to or greater than respective predetermined thresholds in all the parallel coordinates plots of the stakeholders, for example. Note that a parallel coordinates plot in which the common portion is expressed so as to be visually identifiable is stored into the draft agreement data 34 as the draft agreement data of the measures, for example, and is presented to each of the stakeholders.

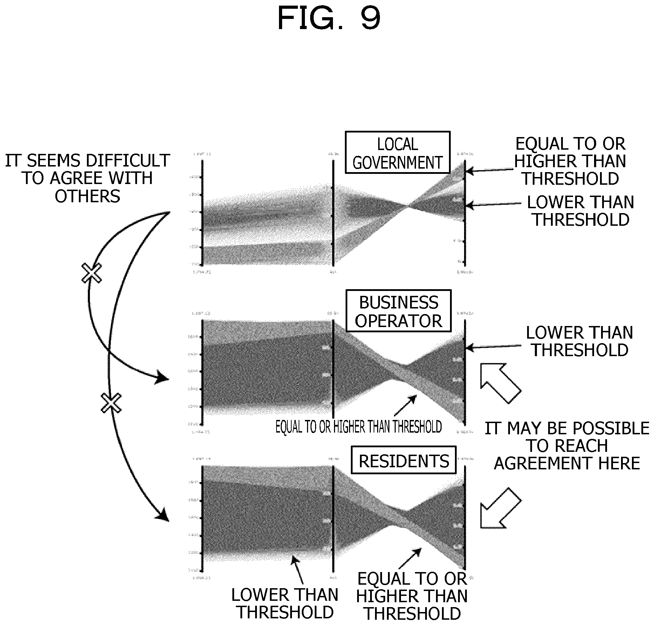

However, there is a problem caused in the formation of the draft agreement data (hereinafter referred to as "consensus formation") by identifying the common portion from the parallel coordinates plot, for example. FIG. 9 is a diagram illustrating an example of a problem in the consensus formation. FIG. 9 is parallel coordinates plots in which the respective evaluation indexes of the parallel coordinates plots for the three respective stakeholders including a local government, a business operator, and residents are expressed by color coding, with respective thresholds of the respective evaluation indexes being the boundaries. More specifically, in FIG. 9, portions "equal to or higher than the threshold" and portions "lower than the threshold" are the portions color-coded, the respective thresholds of the respective evaluation indexes being the boundaries, for example. Note that a threshold is set for each evaluation index, and the scale intervals of the respective axes are not the same or the like. Therefore, as illustrated in FIG. 9, the portions "equal to or higher than the threshold" and the portions "lower than the threshold" are not necessarily aligned in the horizontal direction.

Further, the common portion among the portions in which the respective evaluation indexes are equal to or higher than the respective thresholds in the parallel coordinates plots of all the stakeholders can be adopted as a draft agreement, for example. However, as illustrated in FIG. 9, there is a common portion between the operating division and the residents. However, when the local government is included, there is a problem in that there are no common portions among all the stakeholders, and consensus is not formed. By a conventional method, only the portion that is regarded as the most important portion by each stakeholder can be selected. Even if there is a portion that is regarded as the second most important portion, the portion is left out, and therefore, any common portion is not extracted. Therefore, a plurality of portions that are regarded as important by each stakeholder is allowed to be extracted, so that the number of common portions becomes larger.

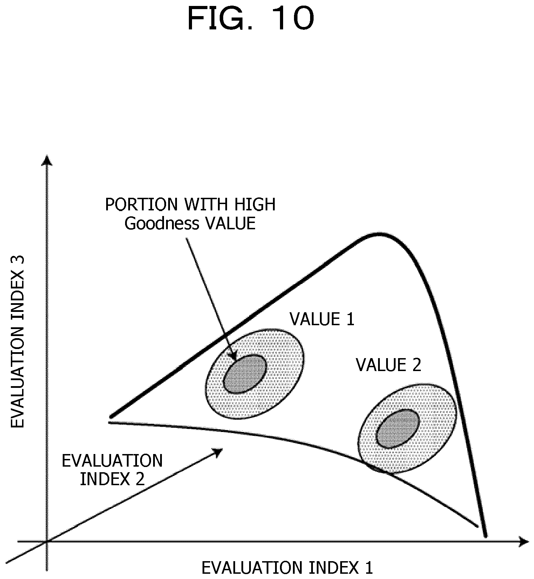

To do so in the present embodiment, as illustrated in "(4) Creation of Goodness Distribution" in FIG. 6, for example, a distribution of goodness of evaluation values (hereinafter referred to as the "goodness distribution") such as a heat map is created based on the results of the relative evaluations made by the respective stakeholders. The goodness distribution is specifically described below with reference to FIG. 10.

FIG. 10 is a diagram illustrating an example of the goodness distribution according to the present embodiment. In the example in FIG. 10, the goodness distribution is created based on a Pareto frontier in an evaluation value space in which evaluation indexes 1 to 3 are represented by the three axes of x-, y-, and z- axes. In FIG. 10, the portion having a triangular shape that is partially curved is the Pareto frontier. For example, the portions in which each evaluation value is equal to or higher than a predetermined threshold (In FIG. 10, the portions indicated as "portions having high goodness value") at points on the Pareto frontier are displayed in shading based on the magnitudes of the evaluation values, which is the goodness distribution. Note that, in FIG. 10, there can be a plurality of "portions having a high goodness value", as indicated as value 1 and value 2. In the present embodiment, to solve the problem of consensus formation as illustrated in FIG. 9, for example, a parallel coordinates plot of each of the stakeholders is created using the goodness distribution, and consensus formation is performed, as illustrated in "(5) Consensus Formation" in FIG. 6.

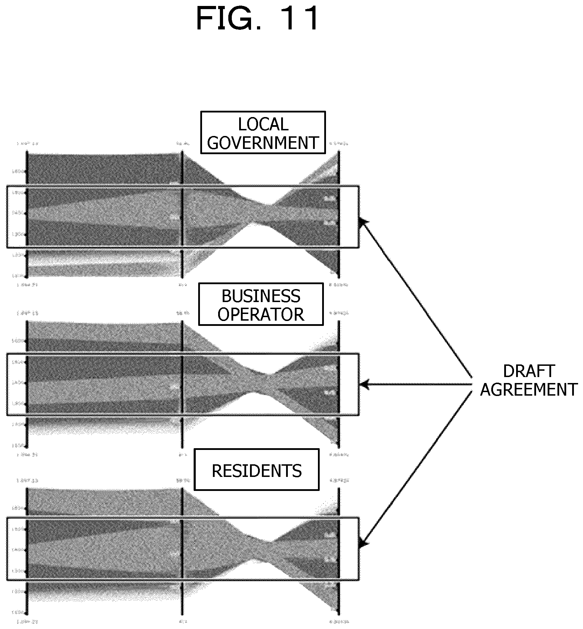

FIG. 11 is a diagram illustrating an example of consensus formation according to the present embodiment. Like FIG. 9, FIG. 11 is parallel coordinates plots in which the respective evaluation indexes of the parallel coordinates plots for the three respective stakeholders including a local government, a business operator, and residents are expressed by color coding, with respective thresholds of the respective evaluation indexes being the boundaries. Each parallel coordinates plot in FIG. 11 is created by narrowing down to a "portion having a high Goodness value" using a goodness distribution, for example. As each parallel coordinates plot is created by narrowing down to the "portions having a high goodness value" using the Goodness distribution in this manner, common portion is increased among all the stakeholders, and the relevant portion can be adopted as a draft agreement, as illustrated in FIG. 11. Note that, as illustrated in FIG. 11, the portion that can be adopted as the draft agreement may include the portion common to all the stakeholders and the peripheral portion thereof, for example. The final consensus decision is made among all the stakeholders who are presented with the draft agreement.

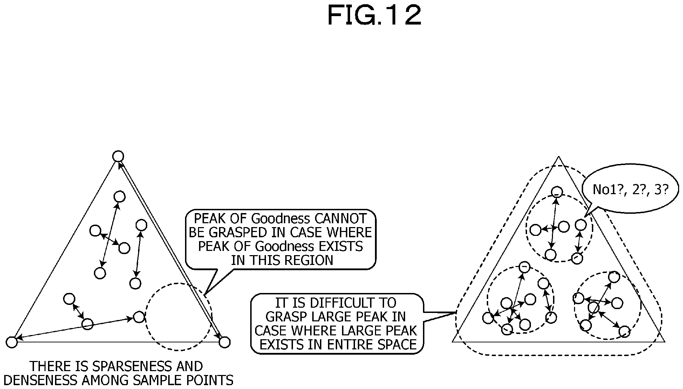

Although the measure search process according to the present embodiment has been described above, there may be a problem in the portion for selecting a pair of measures for performing relative evaluation indicated in "(3) Evaluation by Persons" in FIG. 6, for example. This problem is specifically described below with reference to FIG. 12.

FIG. 12 is a diagram illustrating an example of a problem in relative evaluation pair selection. In FIG. 12, it is assumed that a triangular portion is a Pareto frontier in an evaluation value space in which the evaluation indexes 1 to 3 are expressed by the three axes of the x-, y-, and z-axes, for example. A pair of two points on the Pareto frontier is randomly selected as a pair of measures for performing relative evaluation, for example.

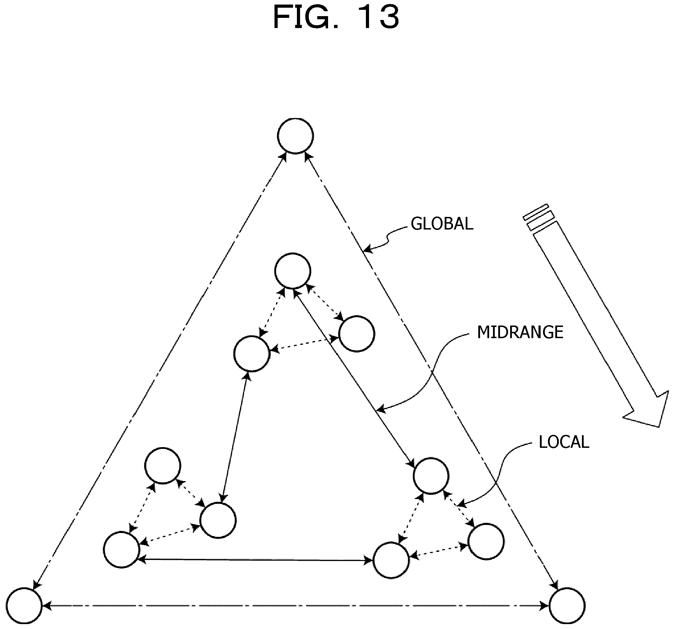

However, depending on the method for selecting a pair on the Pareto frontier, sparseness and denseness occur among the selected sample points, as illustrated on the left side in FIG. 12. For example, a peak of a goodness distribution in a region indicated by a dashed line is not grasped. Also, as illustrated on the right side in FIG. 12, if the selected pair is a local pair, for example, a high peak of a goodness distribution on the entire Pareto frontier is not grasped in some cases. As described above, there is a problem in that multiple peaks to be grasped from the goodness distribution are overlooked depending on the method for selecting a pair on the Pareto frontier. When such a problem occurs, visualization of a plurality of viewpoints such as the best measure among the stakeholders and the second best measure might not be performed correctly, for example. Therefore, in the present embodiment, to grasp the tendency of the goodness distribution comprehensively from the local level to the global level, the selection of a pair of measures for performing the relative evaluation is performed based on a policy of selecting in a stepwise manner, such as from the global level to the midrange level to the local level, for example, instead of selecting at random. The selection of a relative evaluation pair based on the policy is specifically described below with reference to FIGS. 13 to 16.

FIG. 13 is a diagram illustrating an example of the selection of a relative evaluation pair according to the present embodiment. As illustrated in FIG. 13, when a pair to be subjected to relative evaluation is selected from among points on a Pareto frontier in the present embodiment, a pair for grasping a global tendency of the Goodness distribution, a pair for grasping a midrange tendency, and a pair for grasping a local tendency are selected in a stepwise manner.

Here, the Pareto frontier is a continuous space having vertexes and boundaries, and the goodness distribution is a continuous distribution in the space, for example. Therefore, the distance between any two points on the Pareto frontier, and the concepts of global, intermediate, and local can be defined as illustrated in FIG. 13, for example, and the tendency of the goodness distribution can be comprehensively grasped. For example, if the tendency at the vertexes and the centroid of the triangular Pareto frontier is known, the global tendency of the goodness distribution can be grasped. Also, the region of the Pareto frontier is divided, and the midrange tendency of the goodness distribution can be grasped depending on which divided region has a peak of the goodness distribution, for example. Further, the local tendency of the goodness distribution can be grasped depending on which part of each divided region has a peak of the goodness distribution, for example. In view of the above, a method for selecting a pair for each of the global, midrange, and local tendencies is described below in greater detail.

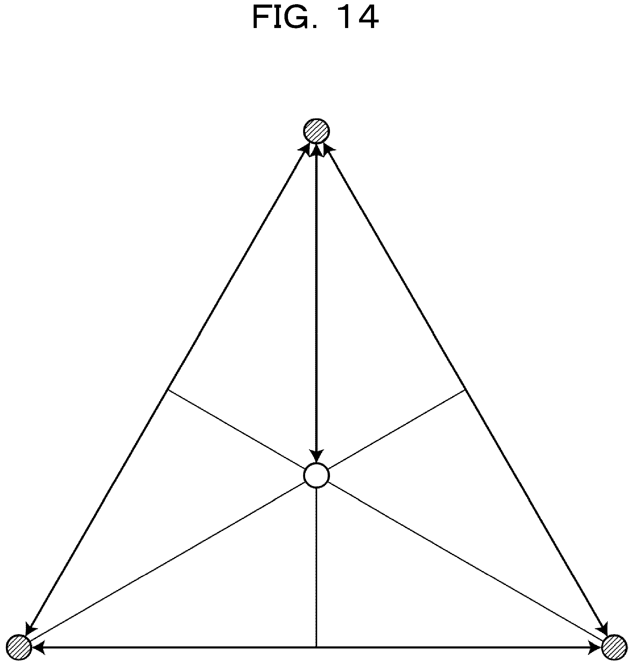

FIG. 14 is a diagram illustrating an example of the global pair selection according to the present embodiment. As illustrated in FIG. 14, the sample points to be used as pairs for the global tendency are the three vertexes of a triangular Pareto frontier and the centroid among those vertexes, for example. Further, as indicated by double-headed arrows in FIG. 14, as the pairs for the global tendency, pairs are formed among the three vertexes in a round-robin manner, for example. As for the centroid, the vertex farthest from the centroid is paired with the centroid. Thus, four pairs are selected.

In other words, each combination of vertexes of each index on the Pareto frontier, and the combination of the centroid among the respective vertexes and the vertex farthest from the centroid are selected as the pairs of measures for performing relative evaluation, for example.

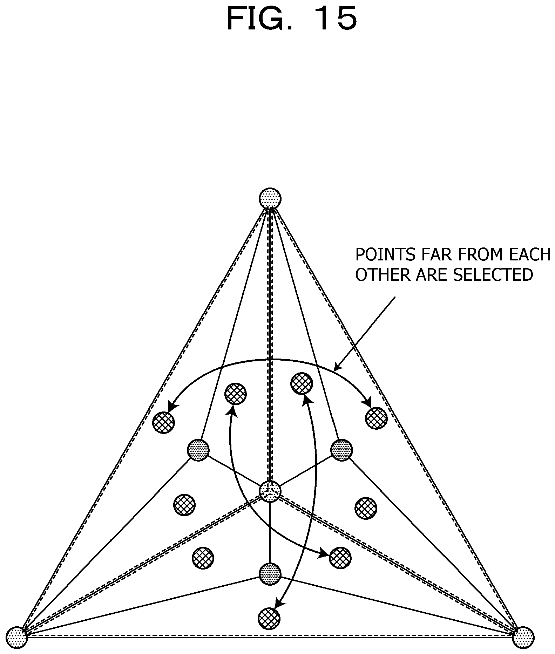

FIG. 15 is a diagram illustrating an example of the midrange pair selection according to the present embodiment. In FIG. 15, as indicated by dashed lines, for example, the region of a Pareto frontier is divided into the triangles formed with the three vertexes and the centroid of the Pareto frontier, which are selected as the sample points to be used as the pairs for the global tendency in FIG. 14. Also, as illustrated in FIG. 15, for example, each of triangles indicated by the dashed lines is further divided into the three triangular regions formed with the centroid among the vertexes of each divided triangle and the respective vertexes. Further, the centroids of the three respective triangles in each of the triangles indicated by the dashed lines are set as the sample points to be used as pairs for the midrange tendency, for example. Furthermore, as indicated by double-headed arrows in FIG. 15, for example, sample points having different triangles each other indicated by the dashed lines are selected as pairs for the midrange tendency. Note that, as illustrated in FIG. 15, for example, a pair of sample points having different triangles each other indicated by the dashed lines is selected so that the distance between the sample points is longer.

In other words, the Pareto frontier is divided into a plurality of triangles formed with the respective vertexes of the respective indexes on the Pareto frontier and the centroid among the vertexes, for example. Also, the triangle is divided by a plurality of second triangles formed with respective second vertexes of the triangle and the second centroid of the triangle, for example. Further, from among the third centroids of the second triangles, for example, a combination of the third centroids that belong to different second triangles and are at a predetermined distance or longer from each other is selected as a pair of measures for performing the relative evaluation.

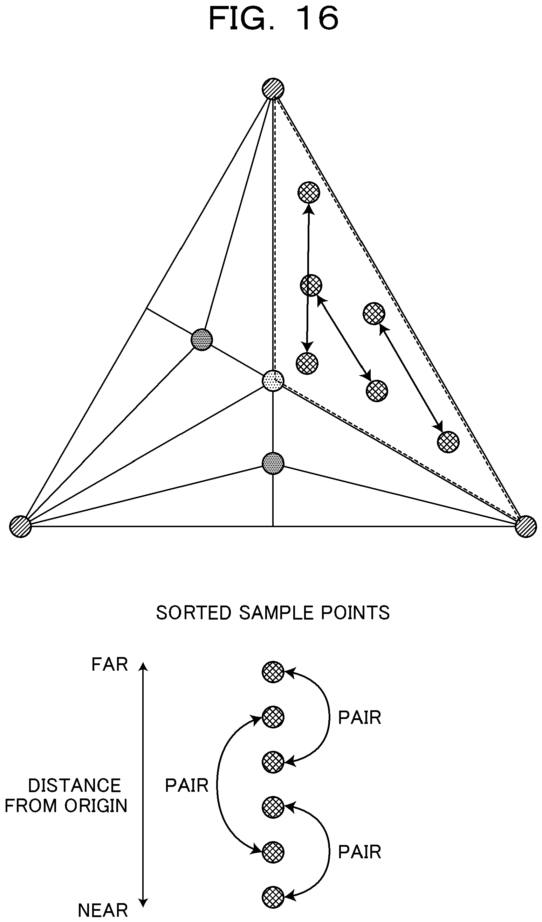

FIG. 16 is a diagram illustrating an example of the local pair selection according to the present embodiment. For example, as illustrated in FIG. 16, sample points to be used as a pair for the local tendency are selected, with uniformity in the evaluation value space within a triangle indicated by dashed lines being taken into consideration. Further, as illustrated in FIG. 16, for example, the respective sample points are sorted by distance from the origin of the evaluation value space, and, as indicated by double-headed arrows in FIG. 16, the sample points are selected as pairs for the local tendency so that the distances between the sample points of all the pairs are longer.

In other words, the pair of measures for performing the relative evaluation is selected from among the combinations of the second points in the second triangles, based on the distance from the origin of the Pareto frontier, for example.

### [Process Flow]

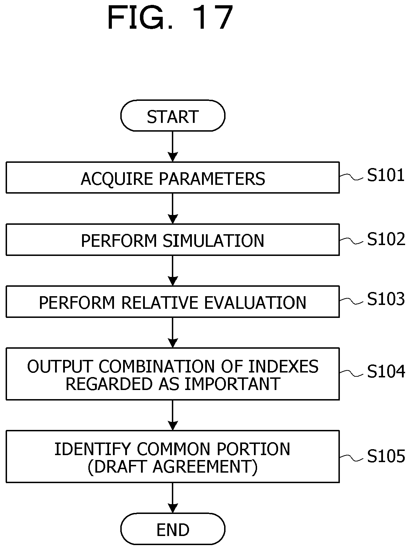

Next, the flow of the measure search process according to the present embodiment is described with reference to FIG. 17. FIG. 17 is a flowchart illustrating an example of the flow of the measure search process according to the present embodiment.

First, as illustrated in FIG. 17, the information processing device 10 acquires a plurality of measure parameters to be used in simulations of measures from the measure parameter data 31, for example (step S101).

Next, the information processing device 10 performs a plurality of simulations of the respective measures as digital rehearsals on the digital twin as an existing technology, using the measure parameters acquired in step S101, for example (step S102).

Next, the information processing device 10 performs, for each stakeholder, the relative evaluation based on the results of the plurality of simulations performed in step S102, for example (step S103).

Next, the information processing device 10 outputs a combination of indexes of a plurality of viewpoints that are regarded as important by the stakeholders with respect to the measures, based on the results of the relative evaluations performed in step S103, for example (step S104).

Next, the information processing device 10 identifies the common portion among all the stakeholders from the combination of the indexes of the plurality of viewpoints that have been output in step S104 and are regarded as important by the stakeholders with respect to the measures, for example, and forms a draft agreement (step S105). After the execution of step S105, the measure search process illustrated in FIG. 17 comes to an end. For example, the draft agreement formed in step S105 is presented to each of the stakeholders via the information processing terminals 100, and a final agreement is determined.

### [Effects]

As described above, the information processing device 10 acquires a plurality of parameters for measures, performs a plurality of simulations of the measures in a virtual space based on the acquired plurality of parameters, performs relative evaluation based on the results of the plurality of simulations performed, outputs a combination of indexes of a plurality of viewpoints that are regarded as important by the stakeholders with respect to the measures based on the results of the relative evaluation, and identifies the common portion among the stakeholders from the output combination.

In this manner, the relative evaluation based on the results of a plurality of simulations for measures is performed, and the common portions of the indexes regarded as important by the stakeholders are identified based on the results of the relative evaluation, to form a draft agreement. Thus, the information processing device 10 may facilitate the stakeholders to agree on a measure against a problem in which multiple evaluation indexes affect one another.

Meanwhile, the process to be performed by the information processing device 10 to perform the relative evaluation includes a process of generating a Pareto frontier based on the results of the plurality of simulations and performing the relative evaluation for each of the stakeholders based on the results of the plurality of simulations on the Pareto frontier.

Thus, the information processing device 10 may facilitate the stakeholders to agree on a measure against a problem in which multiple evaluation indexes affect one another.

Further, the process to be performed by the information processing device 10 to perform the relative evaluation based on the results of the plurality of simulations on the Pareto frontier includes a process of selecting pairs of points on the Pareto frontier based on the respective vertexes of the indexes on the Pareto frontier, and performing the relative evaluation on the pairs.

Thus, the information processing device 10 may capture the tendency of the goodness distribution comprehensively from the local level to the global level.

Further, the process to be performed by the information processing device 10 to select pairs includes a process of selecting each combination of vertexes and a combination of the centroid among the vertexes and the vertex farthest from the centroid as the pairs.

Thus, the information processing device 10 may capture the tendency of the goodness distribution comprehensively from the local level to the global level.

Furthermore, the process to be performed by the information processing device 10 to select pairs includes a process of dividing the Pareto frontier into a plurality of triangles formed with the respective vertexes and the centroid, dividing each triangle into a plurality of second triangles formed with the respective second vertexes of the triangle and the second centroid of the triangle, and selecting, from among the third centroids of the second triangles, the pairs that are combinations of the third centroids that belong to the different second triangles and are at a predetermined distance or longer from each other.

Thus, the information processing device 10 may capture the tendency of the goodness distribution comprehensively from the local level to the global level.

Further, the process to be performed by the information processing device 10 to select the pairs includes a process of selecting a pair from among the combinations of the second points in the second triangles, based on the distance from the origin of the Pareto frontier.

Thus, the information processing device 10 may capture the tendency of the goodness distribution comprehensively from the local level to the global level.

Furthermore, the process to be performed by the information processing device 10 to output the combination includes a process of outputting the combination using a parallel coordinates plot in which points on the Pareto frontier are plotted, with each of the indexes being an axis.

Thus, the information processing device 10 may facilitate the stakeholders to agree on a measure against a problem in which multiple evaluation indexes affect one another.

Further, the process to be performed by the information processing device 10 to identify the common portion includes a process of selecting and identifying the common portion from among the portions in which the respective indexes are equal to or higher than a respective predetermined threshold in all the parallel coordinates plots of the stakeholders.

Thus, the information processing device 10 may facilitate the stakeholders to agree on a measure against a problem in which multiple evaluation indexes affect one another.

### [System]

Pieces of information including the processing procedures, the control procedures, the specific names, the various kinds of data, and the parameters described above or illustrated in the drawings may be changed as appropriate, unless otherwise specified. Also, the specific examples, the distributions, the numerical values, and the like described in the embodiment are merely examples, and may be changed as appropriate.

Furthermore, specific forms of separation and integration of the components of the information processing device 10 are not limited to those illustrated in the drawings. For example, the simulation unit 42 of the information processing device 10 may be separated into a plurality of processing units, or the acquisition unit 41 and the simulation unit 42 of the information processing device 10 may be integrated into one processing unit. That is, all or some of the components may be functionally or physically separated or integrated in optional units, depending on various kinds of loads, use situations, or the like. Moreover, all or any one of the respective processing functions of the respective devices may be implemented by a central processing unit (CPU) and a program analyzed and executed by the CPU, or may be implemented as hardware by wired logic.

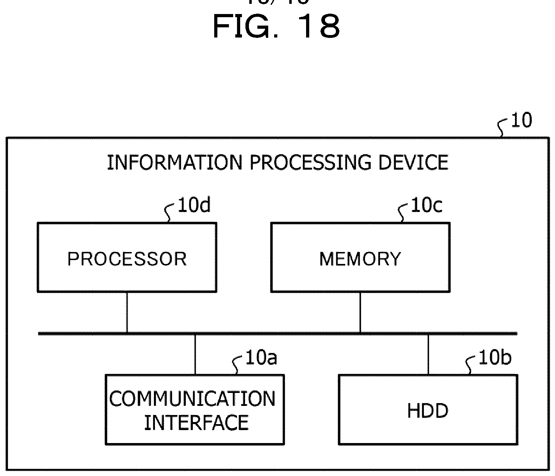

FIG. 18 is a diagram illustrating an example hardware configuration of the information processing device 10 according to the present embodiment. As illustrated in FIG. 18, the information processing device 10 includes a communication interface 10a, a hard disk drive (HDD) 10b,
a memory 10c, and a processor 10d. Furthermore, the respective components illustrated in FIG. 18 are coupled to one another by a bus or the like.

The communication interface 10a is a network interface card or the like, and communicates with another information processing device. For example, in a case where the information processing device 10 is the information processing device 10, the HDD 10b stores programs and data for operating the respective functions illustrated in FIG. 2 and the like.

The processor 10d is a CPU, a micro processing unit (MPU), a graphics processing unit (GPU), or the like. Alternatively, the processor 10d may be formed with an integrated circuit such as an application specific integrated circuit (ASIC) or a field programmable gate array (FPGA).

The processor 10d reads, from the HDD 10b or the like, a program for performing processes similar to those of the respective processing units illustrated in FIG. 2 and the like, and loads the program into the memory 10c, for example. As a result, the processor 10d is enabled to operate as a hardware circuit that performs a process of implementing the respective functions described with reference to FIG. 2 and the like.

Also, the information processing device 10 can implement functions similar to the functions of the above embodiment by reading the above program from a recording medium with a medium reading device and executing the above read program. Note that the program mentioned in another embodiment is not necessarily executed by the information processing device 10. For example, the embodiment described above may also be applied in a case where an information processing device other than the information processing device 10 executes the program or a case where the information processing device 10 and another information processing device cooperate to execute the program.

The program may be distributed via a network such as the Internet. Alternatively, the program may be stored in a computer-readable recording medium such as a hard disk, a flexible disk (FD), a compact disc read only memory (CD-ROM), a magneto-optical disk (MO), or a digital versatile disc (DVD). Then, the program may be then read from the recording medium and be executed by the information processing device 10 or the like.

## Claims

1. An information processing program for causing a computer to perform a process comprising:
acquiring a plurality of parameters for a measure;
performing a plurality of simulations of the measure in a virtual space, based on the plurality of parameters acquired;
performing relative evaluation based on results of the plurality of simulations performed;
outputting a combination of indexes of a plurality of viewpoints that are regarded as important by stakeholders with respect to the measure, based on a result of the relative evaluation; and
identifying a portion that is common among the stakeholders from the output combination.

2. The information processing program according to claim 1, wherein the performing the relative evaluation includes:
generating a Pareto frontier, based on the results of the plurality of simulations; and
performing the relative evaluation for each of the stakeholders, based on the results of the plurality of simulations on the Pareto frontier.

3. The information processing program according to claim 2, wherein the performing the relative evaluation based on the results of the plurality of simulations on the Pareto frontier includes:
selecting pairs of points on the Pareto frontier, based on respective vertexes of the indexes on the Pareto frontier; and
performing the relative evaluation on the pairs.

4. The information processing program according to claim 3, wherein the selecting the pairs includes
selecting each combination of the vertexes and a combination of a centroid among the vertexes and the vertex farthest from the centroid are selected as the pairs.

5. The information processing program according to claim 4, wherein
the selecting the pairs includes:
dividing the Pareto frontier into a plurality of triangles formed with the respective vertexes and the centroid;
dividing each triangle into a plurality of second triangles formed with respective second vertexes of the triangle and a second centroid of the triangle; and
selecting, from among third centroids of the second triangles, the pairs that are combinations of the third centroids that belong to different second triangles and are at a predetermined distance or longer from each other.

6. The information processing program according to claim 5, wherein
the selecting the pairs includes
selecting the pairs from among combinations of second points in the second triangles, based on distance from an origin of the Pareto frontier.

7. The information processing program according to any one of claims 2 to 6, wherein
the outputting the combination includes
outputting the combination using a parallel coordinates plot in which points on the Pareto frontier are plotted, with each of the indexes being an axis.

8. The information processing program according to claim 7, wherein
the identifying the common portion includes
selecting and identifying the common portion from among portions in which each of the indexes is equal to or more than each predetermined threshold in the parallel coordinates plots of all the stakeholders.

9. An information processing device comprising
a control unit that performs a process including:
acquiring a plurality of parameters for a measure;
performing a plurality of simulations of the measure in a virtual space, based on the plurality of parameters acquired;
performing relative evaluation based on results of the plurality of simulations performed;
outputting a combination of indexes of a plurality of viewpoints that are regarded as important by stakeholders with respect to the measure, based on a result of the relative evaluation; and
identifying a portion that is common among the stakeholders from the output combination.

10. An information processing method implemented by a computer to perform a process including:
acquiring a plurality of parameters for a measure;
performing a plurality of simulations of the measure in a virtual space based on the plurality of parameters acquired;
performing relative evaluation based on results of the plurality of simulations performed;
outputting a combination of indexes of a plurality of viewpoints that are regarded as important by stakeholders with respect to the measure, based on a result of the relative evaluation; and
identifying a portion that is common among the stakeholders from the output combination.
